# FASCICULE DE BREVET EUROPEEN

(11) **EP 0 728 230 B1**
(45) Date de publication et mention de la délivrance du brevet: **27.10.1999**
(21) Numéro de dépôt: 95901481.2
(22) Date de dépôt: 10.11.1994
(51) Int. Cl.: C30B 23/02

(54) **PROCEDE DE DEPOT DE COUCHES MONOMOLECULAIRES**
VERFAHREN ZUM ABSCHEIDEN MONOMOLEKULARER SCHICHTEN
METHOD OF DEPOSITING MONOMOLECULAR LAYERS

(30) Priorité: 12.11.1993 FR 9313511
(43) Date de publication de la demande: 28.08.1996
(73) Titulaire: Lewiner, Jacques, 92210 Saint-Cloud (FR); UFINNOVA, 75009 Paris (FR); Lagues, Michel, 92260 Fontenay-aux-Roses (FR)
(72) Inventeur: LAGUES, Michel, F-92260 Fontenay-aux-Roses (FR)
(74) Mandataire: Burbaud, Eric
(86) Numéro de dépôt international: FR9401321
(87) Numéro de publication internationale: WO9513409

(56) Documents cités:
- PHYSICA C, vol.162-164, Décembre 1989, NETHERLANDS, PAGE(S) 627 - 628 Schuhl A et al 'As deposited epitaxial Dy1Ba2Cu3O thin films by MBE'
- PHYSICS AND CHEMISTRY OF MOLECULAR AND OXIDE SUPERCONDUCTORS. SATELLITE CONFERENCE TO LT20, EUGENE, OR, USA, 27-31 JULY 1993, ISSN 0896-1107, JOURNAL OF SUPERCONDUCTIVITY,US, FEB. 1994, USA, PAGE(S) 221 - 225 Lagues M et al 'Sequential imposed layer epitaxy of cuprate films'
- JOURNAL OF THE LESS-COMMON METALS, VOL 164,165, 15 OCT. 1990, SWITZERLAND, PAGE(S) 695 - 702 Luzeau P et al 'BiSrCaCuO films made by coevaporation: influence of the initial composition'
- JOURNAL OF CRYSTAL GROWTH, VOL 115, DEC. 1991, NETHERLANDS, PAGE(S) 745 - 751 Terashima T et al 'Growth mechanism and superconducting properties of ultrathin YBa/sub 2/Cu/sub 3/O/sub 7-x/ films'
- THIN SOLID FILMS, VOL216, 28 AUG. 1992, SWITZERLAND, PAGE(S) 8 - 13 Eckstein J N et al 'Atomically layered growth and properties of high temperature superconducting single-crystal films and superlattices'
- JOURNAL OF CRYSTAL GROWTH, OCT. 1992, NETHERLANDS, VOL. 123, NR. 3-4, PAGE(S) 357 - 365 Ishizuka Y et al 'Growth mechanism for (11n) orientations in Bi-Sr-Ca-Cu-O thin films'
- ED: L. CORRERA 'HIGH TC SUPERCONDUCTOR THIN FILMS' 1992 , ELSEVIER SCIENCE PUBLISHERS B.V , NETHERLANDS voir page 511 - page 516

## Description

La présente invention concerne un procédé pour déposer sous vide une couche monomoléculaire sur une surface réceptrice, cette couche monomoléculaire comportant au moins un élément choisi dans les groupes IIa, IIIa, IVa, VIIIa, Ib, IIb, IIIb, Vb de la classification périodique des éléments (IUPAC - 1970) ou un élément susceptible de présenter une valence mixte, ledit procédé comportant les étapes consistant à chauffer la surface réceptrice à une température prédéterminée inférieure à 600 °C et à faire évaporer sous vide au moins l'élément susmentionné pour le faire déposer sur la surface réceptrice, le flux atomique total du ou des éléments susmentionnés arrivant sur ladite surface étant ajusté entre 10¹² et 10¹⁵ atomes/cm².s.

Tel qu'employé ici, le terme "couche monomoléculaire" signifie une couche constituée par une épaisseur unique des atomes ou molécules constituant ladite couche.

Un procédé tel que défini ci-dessus a été décrit notamment par SCHUHL et al. [Physica C 162-164 (1989), pages 627-628, Elsevier North-Holland].

Il s'avère en pratique que la formation d'une couche strictement monomoléculaire est extrêmement délicate, du fait que l'élément qui se dépose sur la surface réceptrice a naturellement tendance à former des agrégats à trois dimensions, c'est-à-dire des agrégats ayant une épaisseur constituée par plusieurs couches superposées des espèces chimiques qui constituent normalement la couche monomoléculaire. En effet, les agrégats à trois dimensions sont plus stables énergétiquement qu'une couche strictement monomoléculaire.

La formation de tels agrégats est en général irréversible, et elle présente des conséquences dommageables sur les propriétés du matériau formé par dépôt sur la surface réceptrice, notamment, mais non uniquement, lorsque ledit matériau est un matériau supraconducteur.

En outre, lorsque plusieurs couches monomoléculaires sont déposées successivement les unes sur les autres, la formation d'un agrégat à trois dimensions sur une couche favorise aussi l'apparition de tels agrégats sur les couches suivantes, de sorte que les propriétés des couches suivantes sont elles aussi perturbées.

La présente invention a notamment pour but d'éviter ces inconvénients.

A cet effet, selon la présente invention, un procédé du genre en question est essentiellement caractérisé en ce qu'on surveille en temps réel la formation de la couche monomoléculaire, et en ce qu'on arrête l'évaporation de l'élément lorsqu'on détecte la formation complète de la couche monomoléculaire.

Bien entendu, ce procédé permet de déposer successivement plusieurs couches monomoléculaires identiques, auquel cas on arrête l'évaporation de l'élément déposé seulement lorsque le dépôt de la dernière couche monomoléculaire est arrêté, cette dernière couche constituant la couche monomoléculaire mentionnée ci-dessus.

Le contrôle de la température de la surface réceptrice et du flux de l'élément déposé arrivant sur cette surface réceptrice permet d'éviter l'apparition d'agrégats d'atomes à trois dimensions au cours de la formation de la couche monomoléculaire.

Le flux d'atomes de l'élément déposé sur la surface réceptrice doit de façon générale être compris entre une valeur minimale en deçà de laquelle on ne peut pas former de couche monoatomique, et une valeur maximale au-delà de laquelle on forme obligatoirement des agrégats d'atomes à trois dimensions qui empêchent la formation d'une couche strictement monoatomique. Ces valeurs minimale et maximale sont déterminées expérimentalement pour chaque élément à déposer en fonction de son mécanisme de croissance particulier.

En outre, l'arrêt de l'évaporation de l'élément déposé dès que la couche monomoléculaire est terminée, permet d'éviter la formation d'agrégats atomiques à trois dimensions qui seraient dus à un surplus dudit élément déposé.

Dans des modes de réalisation avantageux, on a recours en outre à l'une et/ou à l'autre des dispositions suivantes :
- la formation de la couche monomoléculaire est surveillée par diffraction par réflexion d'électrons de haute énergie (RHEED), en mesurant l'intensité des raies de diffraction des électrons, la formation complète de la couche monomoléculaire étant détectée lorsque ladite intensité atteint un deuxième extremum après passage par un premier extremum pendant la formation de la couche monomoléculaire ;
- la couche monomoléculaire comporte en outre l'élément oxygène, qui est incorporé à ladite couche monomoléculaire pendant le dépôt de l'élément susmentionné, en créant au voisinage de la surface réceptrice une pression locale en oxygène atomique comprise entre 10⁻⁶ et 10 Pa ;
- la pression locale en oxygène atomique est comprise entre 10⁻⁵ et 10 Pa, et en même temps qu'on crée cette pression en oxygène atomique, on crée au voisinage de la surface réceptrice une pression en oxygène moléculaire comprise entre 10⁻⁴ et 100 Pa ;
- la température prédéterminée de la surface réceptrice est au moins égale à 300°C ;
- l'élément choisi dans les groupes IIa, IIIa, IVa, VIIIa, Ib, IIb, IIIb, Vb est choisi parmi : Ca, Cu, Bi, Tl, Hg, Sr, ou dans la famille des lanthanides ;
- on dépose successivement plusieurs couches monomoléculaires sur un substrat ;
- l'ensemble des couches monomoléculaires déposées sur le substrat forme un film supraconducteur ;
- le chauffage a lieu à une température comprise entre 100 et 300°C.

D'autres caractéristiques et avantages du procédé selon l'invention apparaîtront au cours de la description suivante d'un mode de réalisation préféré, donné à titre d'exemple non limitatif, en regard des dessins joints.

Sur les dessins :
- la figure 1 est une vue schématique en coupe représentant un matériau supraconducteur qui peut être obtenu grâce au procédé selon l'invention,
- la figure 2 est une vue schématique d'un appareillage permettant de mettre en oeuvre le procédé selon l'invention, et
- la figure 3 est une vue représentant l'évolution au cours du temps de l'intensité d'une raie de diffraction électrique RHEED pendant le dépôt d'une couche monomoléculaire.

Le procédé selon l'invention va être décrit ci-après dans un cas particulier d'application où il est utilisé pour réaliser un matériau supraconducteur qui se présente sous la forme d'un film multicouches déposé sur un substrat 1 parfaitement poli, de préférence un monocristal de titanate de strontium (SrTiO₃) ou éventuellement d'oxyde de magnésium (MgO), ou tout autre substrat.

Le film qui est déposé sur le substrat 1 est constitué de couches monomoléculaires superposées les unes aux autres.

Ces couches monomoléculaires sont réparties en deux types d'ensembles : des réservoirs de charges électriques R, qui dans l'exemple représenté sont constitués chacun par trois couches successives 2, 3, 2, et des cellules supraconductrices S, qui sont constituées par un certain nombre n de couches supraconductrices 4 séparées deux à deux par des couches intercalaires 5, n étant égal à 4 dans l'exemple représenté mais pouvant être supérieur à 4.

Le film multicouches déposé sur le substrat 1 comporte en général plusieurs cellules supraconductrices S et plusieurs réservoirs de charges R superposés en alternance.

Le nombre n de couches supraconductrices 4 contenues dans une cellule supraconductrice peut éventuellement être différent d'une cellule supraconductrice S à l'autre.

Dans ce cas particulier, les couches supraconductrices 4 sont constituées d'un oxyde de cuivre de formule chimique CuO₂, et les couches intercalaires 5 sont de formule chimique Ca₁₋ₓBiₓ, x étant un nombre réel supérieur ou égal à 0 et inférieur ou égal à 0,2, les couches intercalaires étant éventuellement incomplètes.

En outre, toujours dans le cas particulier décrit, chaque réservoir de charges R est constitué par deux couches 2 constituées d'un oxyde de calcium, séparés par une couche 3 constituée d'un oxyde métallique, le métal de cet oxyde pouvant être le bismuth, le mercure, ou le thalium, le bismuth étant préféré.

Pour réaliser ce matériau, on utilise, selon l'invention, la technique dite de l'épitaxie par jet moléculaire (MBE).

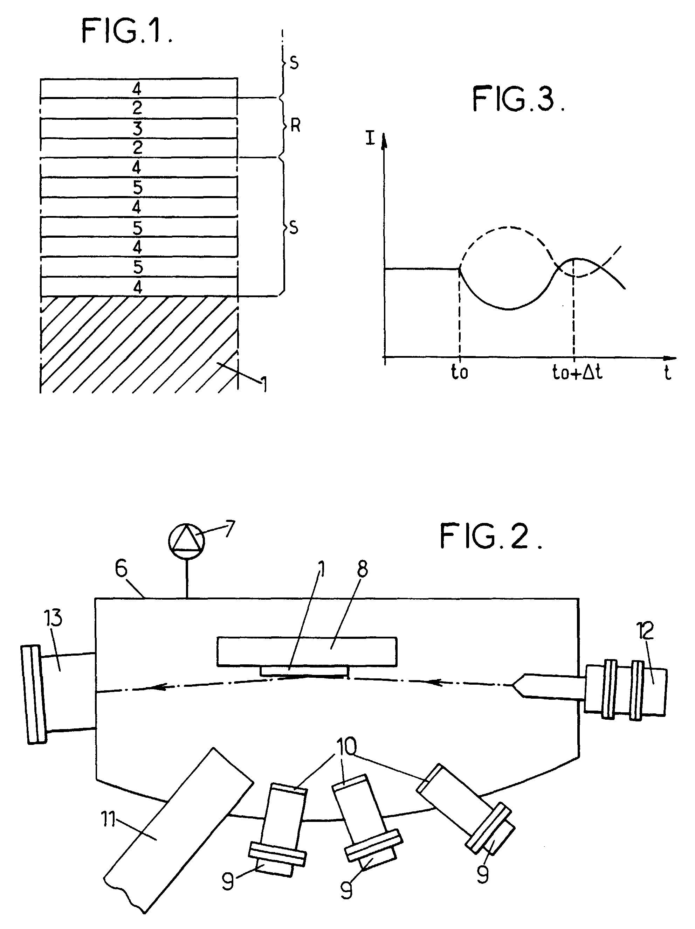

Pour cela, comme représenté sur la figure 2, on dispose le substrat 1 sur un support chauffant 8, dans une chambre à vide 6 reliée à une pompe à vide 7 capable de réaliser un vide poussé.

Le support chauffant chauffe le substrat 1 à une température inférieure à 600°C, et préférentiellement à une température comprise entre 300 et 600°C, notamment entre 300 et 550°C, par exemple entre 300 et 500°C.

La chambre à vide 6 comporte plusieurs cellules de Knudsen, chaque cellule 9 comportant classiquement une charge d'un élément à faire évaporer, des moyens de chauffage pour faire évaporer cet élément dans la chambre à vide, et une ouverture dirigée vers la chambre à vide qui peut être obturée par un couvercle 10. Une fois sous forme de vapeur dans la chambre à vide, l'élément évaporé se condense sur les parois qu'il rencontre, et en particulier sur le substrat 1. Tel qu'employé ici, le terme "évaporer" signifie que des atomes ou des groupes d'atomes quittent la charge contenue dans la cellule de Knudsen sous l'effet d'un apport d'énergie, puis parcourent une certaine distance dans la chambre à vide avant de se déposer sur le substrat 1.

Dans l'exemple représenté, le dispositif comporte trois cellules 9, permettant de faire évaporer respectivement du cuivre, du calcium, et du bismuth.

Pour chaque cellule 9, la fermeture du couvercle 10 permet d'empêcher la pénétration dans la chambre à vide des vapeurs de l'élément chauffé dans ladite cellule 9. En outre, il est possible de régler la puissance de chauffage de chaque cellule. Ceci permet de régler au préalable la vitesse d'évaporation du matériau contenu dans chaque cellule, et donc le flux atomique de ce matériau arrivant sur le substrat 1 ou sur une couche déjà déposée sur le substrat 1.

En outre, la puissance de chauffage de chaque cellule de Knudsen 9 est réglée au préalable pour que le flux d'atomes provenant des différentes cellules de Knudsen 9 en fonctionnement à un instant donné, soit compris entre 10¹² et 10¹⁵ atomes/cm².s, notamment entre 10¹² et 10¹⁴ atomes/cm².s et de préférence voisin de 10¹³ atomes/cm².s, ce qui correspond sensiblement à la réalisation d'une couche en 100 secondes.

En outre, le dispositif comporte une source d'oxygène atomique 11 qui peut être par exemple la source OPS (oxygène plasma source) commercialisée par la société RIBER (France).

Pour la réalisation des couches comportant de l'oxygène, la source d'oxygène moléculaire 11 crée au voisinage du substrat 1 une pression locale en oxygène atomique comprise entre 10⁻⁶ et 10 Pa, notamment entre 10⁻⁶ et 1 Pa, par exemple entre 10⁻⁴ et 10⁻³ Pa.

De plus, dans les exemples de mise en ouvre du procédé de réalisation du matériau selon l'invention, la source d'oxygène atomique utilisée produisait une pression locale en oxygène moléculaire sensiblement égal à 10 fois la pression locale en oxygène atomique.

Enfin, le dispositif comporte un système de diffraction par réflexion d'électrons à haute énergie (RHEED), ce système comportant un canon à électrons 12, capable d'accélérer un faisceau d'électrons sous une énergie qui peut être par exemple de 35 kev, et un écran fluorescent 13.

Lors de la réalisation de chaque couche monomoléculaire du film supraconducteur, le ou les couvercles 10 des cellules de Knudsen 9 correspondant aux éléments à déposer dans ladite couche sont ouverts et les autres restent fermés. Les cellules sont chauffées en permanence, seuls les couvercles 10 permettant d'interrompre le dépôt.

Par exemple, pour réaliser une couche supraconductrice 4 de cuprate, seul le couvercle 10 de la cellule de Knudsen 9 contenant du cuivre est ouvert.

Pour réaliser une couche intercalaire 5, le couvercle 10 de la cellule de Knudsen 9 contenant du calcium est ouvert. Le couvercle 10 de la cellule de Knudsen 9 contenant du bismuth est éventuellement ouvert lui aussi si x est différent de 0. Les puissances de chauffage des deux cellules de Knudsen contenant du calcium et du bismuth sont réglées au préalable de façon que le flux total d'atomes de calcium et de bismuth arrivant sur la dernière couche déposée soit compris entre 10¹² et 10¹⁵ et notamment entre 10¹² et 10¹⁴ atomes/cm².s, notamment et pour respecter la proportion voulue entre le bismuth et le calcium.

La source d'oxygène atomique 11 est dans tous les cas en fonctionnement. En outre, pour déposer une couche 2, le couvercle 10 de la cellule de Knudsen 9 contenant du calcium est ouvert.

De même, pour réaliser une couche 3, le couvercle 10 de la cellule de Knudsen 9 contenant du bismuth est ouvert.

Au cours du dépôt de chaque couche monoatomique, l'écran 13 est surveillé.

Cette surveillance permet tout d'abord de détecter toute formation éventuelle d'agrégats à trois dimensions, qui pourrait avoir lieu malgré les précautions prises. Une telle formation d'agrégats est détectée par l'apparition de points sur l'écran. Dans ce cas, la fabrication du film supraconducteur est arrêtée et le film commencé est mis au rebut.

En outre, l'écran 13 fait normalement apparaître un réseau de lignes lumineuses parallèles que nous appellerons ici "raies de diffraction", et dont l'intensité lumineuse spéculaire I est mesurée au cours du temps, comme représenté sur la figure 3. Ainsi, au début de la réalisation d'une nouvelle couche à partir d'un instant t₀ entraîne en général une baisse de l'intensité I, qui passe d'abord par un minimum, puis qui atteint un maximum à un instant t₀ + Δt (courbe en trait plein). Eventuellement, l'intensité I peut d'abord passer par un maximum puis atteindre un minimum à t₀ + Δt (courbe en pointillés).

Selon l'invention, les couvercles 10 des cellules de Knudsen en fonctionnement pour la réalisation de cette couche sont fermés à l'instant t₀ + Δt, et la source d'oxygène atomique est également arrêtée à cet instant.

On évite ainsi la formation d'agrégats d'atomes à trois dimensions qui seraient dus à un surplus de matière par rapport à la quantité minimale nécessaire pour obtenir une couche monomoléculaire.

Après réalisation du film supraconducteur complet, celui-ci est sorti de la chambre à vide 6, puis de préférence chauffé pendant quelques minutes, par exemple à 100°C, et en général à moins de 300°C, sous une atmosphère d'oxygène moléculaire ou une autre atmosphère oxydante sous une pression supérieure à 100 Pa, par exemple une pression d'une atmosphère.

Le procédé selon l'invention n'est pas limité à l'exemple décrit, mais il en embrasse au contraire toute les variantes, notamment celles dans lesquelles :
- les jets moléculaires sont obtenus non plus par des cellules de Knudsen, mais par chauffage d'un matériau par un canon à électrons, ou par ablation laser,
- le support 8 n'est pas chauffant, et seule la surface du substrat ou de la dernière couche déposée est chauffée, par exemple par un faisceau laser ou autre.

## Revendications

1. Procédé pour déposer sous vide une couche monomoléculaire sur une surface réceptrice, cette couche monomoléculaire comportant au moins un élément choisi dans les groupes IIa, IIIa, IVa, VIIIa, Ib, IIb, IIIb, Vb de la classification périodique des éléments (IUPAC - 1970), ou un élément susceptible de présenter une valence mixte,
ledit procédé comportant les étapes consistant à chauffer la surface à une température prédéterminée (T) inférieure à 600°C et à faire évaporer sous vide au moins l'élément susmentionné pour le faire déposer sur la surface réceptrice, le flux atomique total du ou des éléments susmentionnés arrivant sur ladite surface réceptrice étant compris entre 10¹² et 10¹⁵ atomes/cm².s,
**caractérisé en ce qu'**on surveille en temps réel la formation de la couche monomoléculaire, et en ce qu'on arrête l'évaporation de l'élément lorsqu'on détecte la formation complète de la couche monomoléculaire.

2. Procédé selon la revendication 1, dans lequel la formation de la couche monomoléculaire est surveillée par diffraction par réflexion d'électrons de haute énergie, en mesurant l'intensité des raies de diffraction des électrons, la formation complète de la couche monomoléculaire étant détectée lorsque ladite intensité atteint un deuxième extremum après passage par un premier extremum pendant la formation de la couche monomoléculaire.

3. Procédé selon l'une quelconque des revendications 1 et 2, dans lequel la couche monomoléculaire comporte en outre l'élément oxygène, qui est incorporé à ladite couche monomoléculaire pendant le dépôt de l'élément susmentionné, en créant au voisinage de la surface réceptrice une pression locale en oxygène atomique comprise entre 10⁻⁶ et 10 Pa.

4. Procédé selon la revendication 3, dans lequel la pression locale en oxygène atomique est comprise entre 10⁻⁵ et 10 Pa, et dans lequel, en même temps qu'on crée cette pression en oxygène atomique, on crée au voisinage de la surface réceptrice une pression en oxygène moléculaire comprise entre 10⁻⁴ et 100 Pa.

5. Procédé selon l'une quelconque des revendications précédentes, dans lequel la température prédéterminée (T) de la surface réceptrice est au moins égale à 300°C.

6. Procédé selon l'une quelconque des revendications précédentes, dans lequel l'élément choisi dans les groupes IIa, IIIa, IVa, VIIIa, Ib, IIb, IIIb, Vb est choisi parmi : Ca, Cu, Bi, Tl, Hg, Sr, ou dans la famille des lanthanides.

7. Procédé selon l'une quelconque des revendications précédentes, dans lequel on dépose successivement plusieurs couches monomoléculaires (2, 3, 4, 5) sur un substrat (1).

8. Procédé selon la revendication 7, dans lequel l'ensemble des couches monomoléculaires (2, 3, 4, 5) déposées sur le substrat (1) forme un film supraconducteur.

9. Procédé selon l'une quelconque des revendications précédentes, comportant une étape finale consistant à chauffer le substrat (1) et la ou les couches monomoléculaires (2, 3, 4, 5) qui ont été déposées sur ce substrat, sous une atmosphère oxydante.

10. Procédé selon la revendication 9, dans lequel le chauffage a lieu à une température comprise entre 100 et 300°C.

## Patentansprüche

1. Verfahren zum Abscheiden einer monomolekularen Schicht im Vakuum auf eine Aufnahmefläche, wobei die monomolekulare Schicht wenigstens ein aus den Gruppen IIa, IIIa, IVa, VIIIa, Ib, IIb, IIIb, Vb des Periodensystems (IUPAC - 1970) ausgewähltes Element oder ein geeignetes Element mit gemischter Wertigkeit enthält, wobei das Verfahren Verfahrensschritte umfaßt, die darin bestehen, daß die Oberfläche auf eine vorbestimmte, unter 600°C liegende Temperatur (T) erhitzt und wenigstens das genannte Element zum Abscheiden auf der Aufnahmefläche im Vakuum verdampft wird, wobei die gesamte Teilchendichte an Atomen des genannten Elements bzw. der genannten Elemente, die auf der genannten Aufnahmefläche auftreffen, zwischen 10¹² und 10¹⁵ Atomen/cm² · s liegt,
dadurch gekennzeichnet, daß die Bildung der monomolekularen Schicht in Echtzeit überwacht und die Verdampfung des Elements beendet wird, sobald festgestellt wird, daß die Ausbildung der monomolekularen Schicht abgeschlossen ist.

2. Verfahren nach Anspruch 1, wobei die Ausbildung der monomolekularen Schicht mittels Diffraktion bei der Reflexion energiereicher Elektronen durchgefuhrt wird, wobei die Intensität der Diffraktionsstrahlen der Elektronen gemessen wird, wobei dann festgestellt wird, daß die Ausbildung der monomolekularen Schicht abgeschlossen ist, wenn die Intensität einen zweiten Extremwert erreicht, nachdem sie während der Ausbildung der monomolekularen Schicht einen ersten Extremwert durchlaufen hat.

3. Verfahren nach einem der Ansprüche 1 und 2, wobei die monomolekulare Schicht unter anderem das Element Sauerstoff umfaßt, das während der Abscheidung des oben genannten Elements in die monomolekulare Schicht miteingebracht wird, wobei nahe der Aufnahmefläche ein lokaler Sauerstoffatom-Druck zwischen 10⁻⁶ und 10 Pa auftritt.

4. Verfahren nach Anspruch 3, wobei der lokale Sauerstoffatom-Druck zwischen 10⁻⁵ und 10 Pa liegt und wobei gleichzeitig mit der Erzeugung des Sauerstoffatom-Drucks nahe der Aufnahmefläche ein Sauerstoffmolekül-Druck zwischen 10⁻⁴ und 100 Pa erzeugt wird.

5. Verfahren nach einem der vorangegangenen Ansprüche, wobei die vorbestimmte Temperatur (T) der Aufnahmefläche bei wenigstens 300°C liegt.

6. Verfahren nach einem der vorangegangenen Ansprüche, wobei das aus den Gruppen IIa, IIIa, IVa, VIIIa, Ib, IIb, IIIb, Vb ausgewählte Element zu den Elementen Ca, Cu, Bi, Tl, Hg, Sr oder zur Familie der Lanthanide gehört.

7. Verfahren nach einem der vorangegangenen Ansprüche, wobei nacheinander mehrere monomolekulare Schichten (2, 3, 4, 5) auf einem Substrat (1) abgeschieden werden.

8. Verfahren nach Anspruch 7, wobei die monomolekularen, auf dem Substrat (1) abgeschiedene Schichten (2, 3, 4, 5) zusammen einen supraleitenden Film bilden.

9. Verfahren nach einem der vorangegangenen Ansprüche enthaltend einen letzten Arbeitsschritt, bei dem das Substrat (1) und die auf dem Substrat abgeschiedene monomolekulare Schicht bzw. die abgelagerten monomolekularen Schichten (2, 3; 4, 5) in einer oxidierenden Atmosphäre erhitzt werden.

10. Verfahren nach Anspruch 9, wobei die Erhitzung bei einer Temperatur zwischen 100 und 300°C erfolgt.

## Claims

1. Method of vacuum depositing a monomolecular layer on a host surface, this monomolecular layer including at least one element chosen from groups IIa, IIIa, IVa, VIIIa, Ib, IIb, IIIb, Vb of the Periodic Table of the Elements (IUPAC - 1970), or an element capable of exhibiting a mixed valency, said method including the steps consisting in heating the surface to a predetermined temperature (T) below 600°C and in vacuum evaporating at least the abovementioned element in order to deposit it on the host surface, the total atomic flux of the abovementioned element or elements arriving on said host surface being between 10¹² and 10¹⁵ atoms/cm²·s, characterized in that the formation of the monomolecular layer is monitored in real time, and in that the evaporation of the element is stopped when the complete formation of the monomolecular layer is detected.

2. Method according to claim 1, in which the formation of the monomolecular layer is monitored by reflection high-energy electron diffraction, while measuring the intensity of the electron diffraction lines, the complete formation of the monomolecular layer being detected when said intensity reaches a second extremum after passing through a first extremum during the formation of the monomolecular layer.

3. Method according to either of claims 1 and 2, in which the monomolecular layer further includes oxygen, which is incorporated in said monomolecular layer during the deposition of the abovementioned element, while creating a local atomic oxygen pressure of between 10⁻⁶ and 10 Pa in the vicinity of the host surface.

4. Method according to claim 3, in which the local atomic oxygen pressure is between 10⁻⁵ and 10 Pa, and in which a molecular oxygen pressure of between 10⁻⁴ and 100 Pa is created in the vicinity of the host surface at the same time as this atomic oxygen pressure is created.

5. Method according to any one the preceding claims, in which the predetermined temperature (T) of the host surface is at least equal to 300°C.

6. Method according to any one of the preceding claims, in which the element chosen from groups IIa, IIIa, IVa, VIIIa, Ib, IIb, IIIb, Vb is chosen from: Ca, Cu, Bi, Tl, Hg, Sr, or from the lanthanide series.

7. Method according to any one of the preceding claims, in which a plurality of monomolecular layers (2, 3, 4, 5) are successively deposited on a substrate (1).

8. Method according to claim 7, in which the set of monomolecular layers (2, 3, 4, 5) deposited on the substrate (1) forms a superconducting film.

9. Method according to any one of the preceding claims, including a final step consisting in heating the substrate (1) and the monomolecular layer or layers (2, 3, 4, 5) which have been deposited on this substrate, under an oxidizing atmosphere.

10. Method according to claim 9, in which the heating takes place to a temperature of between 100 and 300°C.
